# DEMANDE DE BREVET EUROPEEN

(11) **EP 2 448 001 A2**
(43) Date de publication de la demande: **02.05.2012**
(21) Numéro de dépôt: 11185895.7
(22) Date de dépôt: 20.10.2011
(51) Int. Cl.: H01L 31/0203, H01L 31/0232, H01L 31/18, H01L 25/16, B29D 11/00, G02B 5/00

(54) **Dispositif optique, procédé pour sa fabrication et boîtier électronique comprenant ce dispositif optique**

(30) Priorité: 28.10.2010 FR 1058895
(71) Demandeur: STMicroelectronics (Grenoble 2) SAS, 38000 Grenoble (FR)
(72) Inventeur: Coffy, Romain, 38950 SAINT MARTIN LE VINOUX (FR)
(74) Mandataire: Zapalowicz, Francis

(57) **Abrégé**

Dispositif optique et procédé pour sa fabrication, dans lesquels au moins une pastille optique (4) est noyée, au moins périphériquement, dans une plaque (2) en une matière d'encapsulation, de telle sorte que la pastille optique puisse être traversée par un rayonnement lumineux, d'un côté à l'autre de la plaque.

Boîtier électronique comprenant un dispositif semi-conducteur (28) comprenant au moins une puce de circuits intégrés optiques (31) et un dispositif optique (29) placé de telle sorte que la pastille optique (4) soit au-dessus des circuits intégrés optiques (31) et un moyen de fixation du dispositif optique (29) sur le dispositif semi-conducteur (28).

## Description

La présente invention concerne le domaine des dispositifs optiques et des dispositifs semi-conducteurs équipés de dispositifs optiques.

On connaît des boîtiers électroniques qui comprennent des puces de circuits intégrés comprenant des éléments optiques, tels que des capteurs ou des émetteurs de rayonnement lumineux, montées sur des plaques supports de connexion électrique et des éléments optiques, tels que des pastilles optiques ou des lentilles, placés devant les éléments optiques des puces et portés par des bagues fixées sur les plaques supports. De tels boîtiers ne sont cependant pas bien adaptés lorsqu'il s'agit de proposer des boîtiers électroniques devant comprendre plusieurs puces de circuits intégrés voisines.

Il est tout d'abord proposé un dispositif optique.

Ce dispositif optique, autonome, comprend au moins une pastille optique et une plaque en une matière d'encapsulation dans laquelle la pastille optique est noyée, au moins périphériquement, une première face de la plaque et une première face de la pastille optique s'étendant dans un même plan formant une surface d'assemblage (1a), une seconde face de la pastille optique opposée à sa première face étant au moins en partie découverte, de telle sorte que la pastille optique puisse être traversée par un rayonnement lumineux, d'un côté à l'autre de la plaque.

Le dispositif optique peut comprendre un élément optique placé du côté de la seconde face de la pastille optique et associé optiquement à cette dernière.

Le dispositif optique peut comprendre, dans la plaque, deux pastilles optiques.

Le dispositif optique peut comprendre, dans la plaque, une pastille optique et un passage traversant, ainsi qu'un élément optique associé à ce passage.

Il est également proposé un procédé de fabrication d'un dispositif optique conçu tel quel.

Ce procédé comprend : placer une première face d'au moins une pastille optique sur une surface d'un moule ; et enrober, sur ladite surface du moule, la pastille optique d'une matière d'encapsulation, de façon à obtenir une couche intermédiaire surmoulée plus épaisse que la pastille optique et présentant une première face sur ladite surface (6a) du moule (6), ladite première face (2a) de la plaque et ladite première face (4a) de la pastille optique s'étendant dans un même plan formant une surface d'assemblage (1a).

Le procédé comprend également réaliser une opération d'enlèvement de la matière d'encapsulation du côté de la seconde face de la couche intermédiaire opposée à sa première face, au moins au-dessus d'au moins une partie d'une seconde face de la pastille optique opposée à sa première face de façon à découvrir cette partie, de façon à obtenir une plaque dans laquelle la pastille optique est noyée au moins périphériquement et que la pastille optique puisse être traversée par un rayonnement lumineux, d'un côté à l'autre de la plaque.

Le procédé peut comprendre : réaliser une opération d'enlèvement et de planarisation de la matière d'encapsulation du côté de la seconde face de la plaque intermédiaire opposée à sa première face, au moins jusqu'à la seconde face de la pastille optique.

Le procédé peut comprendre : réaliser une ouverture dans la couche intermédiaire au moins au dessus d'au moins une partie de la seconde face de la pastille optique, de façon à obtenir une plaque présentant cette ouverture.

Le procédé peut comprendre : monter un élément optique au-dessus de la seconde face de la pastille optique.

Le procédé peut comprendre : enrober la pastille optique sur la surface du moule présentant une partie en saillie, de façon à aménager un évidement dans la couche intermédiaire, l'opération d'enlèvement ouvrant cet évidement pour former un passage traversant dans la plaque.

Le procédé peut comprendre : monter un élément optique au-dessus ou dans le passage traversant dans la plaque.

Il est également proposé un boîtier électronique.

Ce boîtier électronique comprend un dispositif semi-conducteur comprenant au moins une puce de circuits intégrés présentant, d'un côté, au moins des circuits intégrés optiques ; un dispositif optique placé de telle sorte que la pastille optique soit au-dessus des circuits intégrés, dans une position telle que ladite surface d'assemblage (1a) est du côté du dispositif semi-conducteur (28) ; et un moyen de fixation du dispositif optique sur le dispositif semi-conducteur.

Le boîtier électronique peut comprendre une plaque en une matière d'encapsulation dans laquelle la puce est noyée, au moins périphériquement, en laissant découvert ledit élément optique intégré, la plaque du dispositif semi-conducteur étant munie de moyens de connexion électrique d'une face à l'autre, reliés électriquement à la puce.

Le moyen de fixation du dispositif optique sur le dispositif semi-conducteur peut être formé par une couche de colle interposée entre eux.

Le dispositif semi-conducteur comprend au moins un composant passif relié aux moyens de connexion électrique.

Le dispositif semi-conducteur peut comprendre au moins deux puces de circuits intégrés optiques, dont une puce comprenant un émetteur de rayonnement lumineux et une puce comprenant un capteur de rayonnement lumineux, et dans lequel le dispositif optique comprend une pastille au-dessus de l'une des puces et une pastille ou un passage associé à un élément optique au-dessus de l'autre puce.

Des dispositifs optiques et des modes de fabrication de ces derniers, ainsi que des boîtiers électroniques vont maintenant être décrits à titre d'exemples non limitatifs, illustrés par le dessin sur lequel :
- la figure 1 représente une coupe d'un dispositif optique ;
- la figure 2 représente une étape de fabrication du dispositif optique de la figure 1 ;
- la figure 3 représente une autre étape de fabrication du dispositif optique de la figure 1 ;
- la figure 4 représente une autre étape de fabrication du dispositif optique de la figure 1 ;
- la figure 5 représente une variante de réalisation du dispositif optique de la figure 1 ;
- la figure 6 représente une autre variante de réalisation du dispositif optique de la figure 1 ;
- la figure 7 représente une coupe d'un autre dispositif optique ;
- la figure 8 représente une variante de réalisation du dispositif optique de la figure 7 ;
- la figure 9 représente une coupe d'un autre dispositif optique ;
- la figure 10 représente une étape de fabrication du dispositif optique de la figure 9 ;
- la figure 11 représente une autre étape de fabrication du dispositif optique de la figure 9 ;
- la figure 12 représente une autre étape de fabrication du dispositif optique de la figure 9 ;
- la figure 13 représente une variante de réalisation du dispositif optique de la figure 9 ; et
- la figure 14 représente une coupe d'un boîtier électronique.

On va tout d'abord décrire des dispositifs optiques et des opérations permettant leur fabrication.

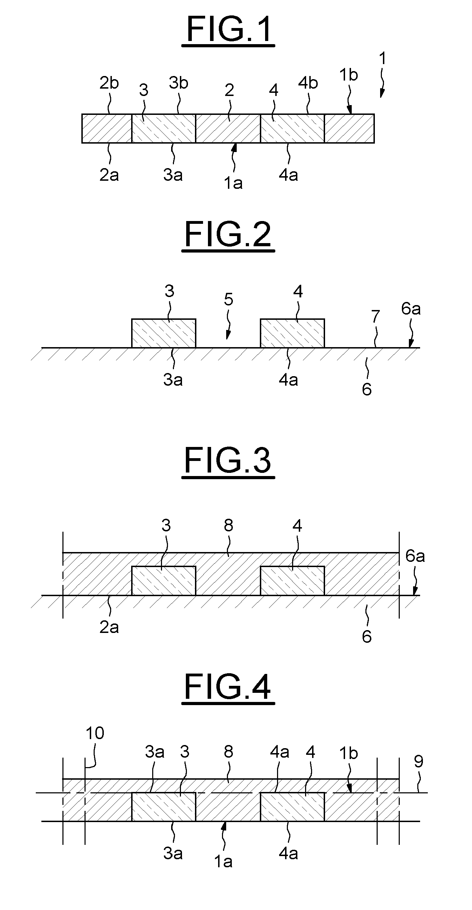

En se reportant à la figure 1, on voit qu'un dispositif optique 1 comprend une plaque 2 en une matière d'enrobage, par exemple une résine époxy, dans laquelle sont noyées, par exemple, deux pastilles optiques 3 et 4 qui peuvent être cylindriques, rectangulaires ou carrées. Le dispositif optique 1 pourrait comprendre une seule pastille ou plus de deux pastilles.

Les pastilles optiques 3 et 4 présentent des premières faces 3a et 4a qui s'étendent dans le même plan qu'une première face 2a de la plaque 2, en formant une face arrière la du dispositif optique 1 formant une surface d'assemblage, et des secondes faces 3b et 4b qui s'étendent dans le même plan qu'une seconde face 2b de la plaque 2, en formant une face avant 1b du dispositif optique 1, ces faces arrière et avant la et 1b étant parallèles. Ainsi, la plaque 2 enrobe ou enveloppe périphériquement les pastilles optiques 3 et 4 et la face arrière forme une face de montage comme on le verra plus loin.

Les pastilles optiques 3 et 4 peuvent être en verre ou en une matière plastique. Elles peuvent être transparentes ou être traitées pour constituer des filtres ou des lentilles.

Pour fabriquer le dispositif optique 1, on peut procéder de la façon suivante.

Comme illustré sur la figure 2, on place des pastilles optiques 3 et 4 sur un emplacement 5 d'une surface plate 6a d'un moule 6, leurs premières faces 3a et 4a étant contre cette surface 6a. Pour le maintien des pastilles optiques 3 et 4, la surface 5a du moule 5 peut être recouverte d'un adhésif pelable 7. En vue d'une fabrication collective, d'autres pastilles optiques 3 et 4 peuvent être placées sur d'autres emplacements 5 de la surface plate 6a du moule 6.

Ensuite, comme illustré sur la figure 3, on coule ou surmoule une couche 8 d'une matière d'enrobage liquide sur la surface 6a du moule 6, cette matière d'enrobage étant plus épaisse que les pastilles optiques 3 et 4 et couvrant ces dernières. La première face 2a de la plaque 2 à fabriquer est alors formée contre la surface 6a du moule 6, dans le même plan que les premières faces 3a et 4a des pastilles optiques 3 et 4.

Ensuite, après durcissement de la matière d'enrobage 8 et extraction du moule 5, comme illustré sur la figure 4, on procède à un enlèvement d'une partie de la couche 11, sur le côté opposé à la première face 2a, jusqu'au niveau 9 des secondes faces 3b et 4b des pastilles optiques 3 et 4 de façon à découvrir ces secondes faces 3b et 4b. Cette opération peut être effectuée par une attaque chimique, mécanique ou mécano-chimique.

Dans la mesure où l'une des pastilles optiques 3 et 4 serait plus épaisse que l'autre, cette opération d'enlèvement consisterait aussi à enlever une partie de la pastille optique la plus épaisse, au moins jusqu'au niveau de la pastille optique la moins épaisse.

Dans le cas d'une fabrication collective, les dispositifs optiques 1 à obtenir peuvent être singularisés par exemple par sciage le long des contours 10.

Le dispositif optique 1 peut être complété par un élément optique associé optiquement à l'une des pastilles optiques 3 et 4 ou d'éléments optiques associés respectivement à ces pastilles optiques.

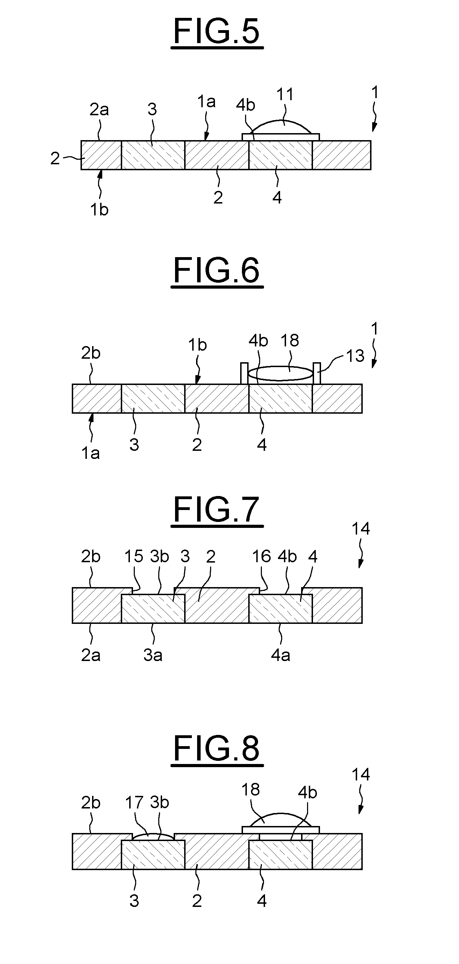

Selon une variante représentée sur la figure 5, une lentille 11 peut être rapportée et fixée sur la face 1b opposée à la face de montage 1a, par exemple par collage d'une face plate de cette dernière sur la seconde face 4b de la pastille optique 4 et/ou sur le bord de la seconde face 2a de la plaque 2 entourant périphériquement la pastille optique 4.

Selon une autre variante représentée sur la figure 6, une lentille 12 peut être portée par une bague 13, cette bague 13 étant fixée par exemple par collage sur la seconde face 4b de la pastille optique 4 et/ou sur la seconde face 2a de la plaque 2.

En se reportant à la figure 7, on voit qu'un dispositif optique 14 se différencie du dispositif optique 1 par le fait que la seconde face 2b de sa plaque 2 est située au-dessus et à distance des secondes faces 3b et 4b des pastilles optiques 3 et 4 et que la plaque 2 présente des ouvertures 15 et 16 qui sont formées dans sa seconde face 2b au-dessus des secondes faces 3b et 4b des pastilles optiques 3 et 4 de façon à découvrir, partiellement ou totalement, ces secondes faces 3b et 4b.

Pour la fabrication du dispositif optique 14, en faisant référence à la figure 3, on peut, après durcissement de la couche 8, qui forme la plaque 2, et extraction du moule 5, procéder à la réalisation des ouvertures 15 et 16 par une attaque chimique, mécanique ou mécano-chimique ou par action d'un rayonnement laser. On peut en outre procéder à une planarisation de la face 2a de la plaque 2.

Comme dans le cas du dispositif optique 1, le dispositif optique 14 peut être équipé en outre d'un élément optique associé optiquement à l'une des pastilles optiques 3 et 4 ou d'éléments optiques associés respectivement à ces pastilles optiques.

Par exemple, comme illustré sur la figure 8, une lentille 17 peut être placée devant et fixée directement sur la seconde face frontale de 3b de la pastille optique 3, dans l'ouverture 15 de la plaque 2, et une lentille 18 placée devant la pastille 4 peut être fixée directement sur la seconde face 2b de la plaque 2, à distance de la seconde face 4b de la pastille optique 4. Les lentilles 17 et 18 peuvent présenter des caractéristiques optiques différentes. L'une et/ou l'autre des lentilles 17 et 18 pourraient être remplacées par la lentille 12 portée par la bague 13 de la figure 6.

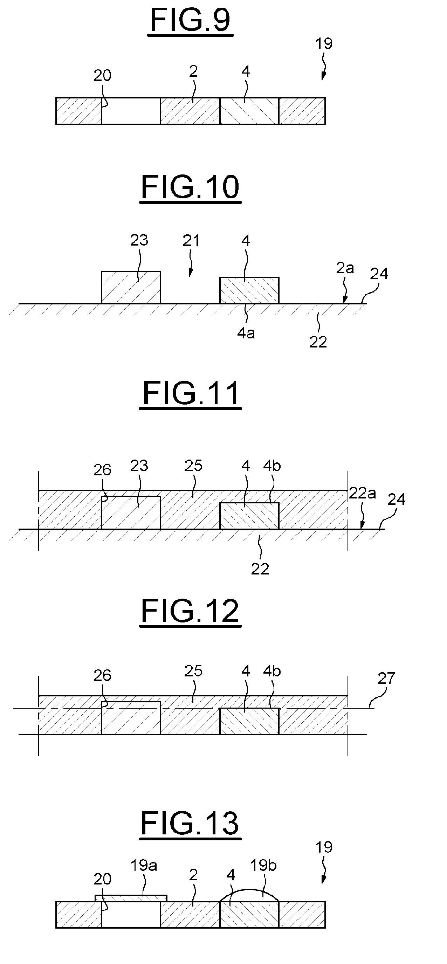

Comme représenté sur la figure 9, un dispositif optique 19 se différencie du dispositif optique 1 par le fait que la pastille optique 3 est inexistante et que la plaque 2 présente, à la place, un passage traversant 20.

Pour fabriquer le dispositif optique 19, on peut procéder de la façon suivante.

Comme illustré sur la figure 10, on place une pastille optique 4 sur un emplacement 21, ou respectivement des emplacements 21 dans le cas d'une fabrication collective, d'une surface plate 22a d'un moule 22. Sur cet emplacement 21, le moule présente une partie en saillie 23 dont la périphérie correspond au passage traversant 20 à obtenir et une épaisseur supérieure à l'épaisseur de la pastille optique 4. La surface 22a peut être recouverte d'un adhésif pelable 24.

Ensuite, comme illustré sur la figure 11 et de façon correspondante à ce qui a été décrit plus haut, on coule une couche 25 d'une matière d'enrobage liquide sur la surface 22a du moule 11, cette couche 25 étant plus épaisse que la partie en saille 23. La partie en saillie 23 du moule 22 forme alors un évidement 26 dans la couche 25.

Ensuite, après durcissement de la matière d'enrobage 8 et extraction du moule 5, on procède, comme illustré sur la figure 12, à un enlèvement d'une partie de la couche 25, jusqu'au niveau 27 de la seconde face 4b de la pastille optiques 4 pour découvrir cette face 4b. Cette opération permet d'ouvrir à l'avant l'évidement 26 de façon à former le passage traversant 20. Après sciage, on obtient alors des dispositifs optiques 19 singularisés.

Selon une variante de réalisation, on pourrait, comme dans le cas de l'exemple de la figure 7, réaliser des ouvertures dans la couche 25, au dessus de la pastille optique 4 et au travers de cette couche 25 au dessus de l'évidement 26 pour former un passage traversant 20. Dans ce cas, la profondeur de l'évidement 26 pourrait être supérieure, égale ou inférieure à l'épaisseur de la pastille optique 4.

Comme dans les exemples précédents, le dispositif optique 19 peut être complété par un élément optique associé optiquement à la pastille optique 4 ou au passage traversant 20, ou d'éléments optiques associés respectivement à la pastille optique 4 et au passage traversant 20.

Par exemple, comme illustré sur la figure 13, le dispositif optique 19 peut être équipé d'une plaque transparente de protection 19a devant le passage traversant 20 et d'une lentille 19b devant la pastille optique 4. Dans une variante de réalisation, la plaque 19a pourrait être remplacée par une lentille et la lentille 19b pourrait être supprimée. La plaque ou la lentille 19a pourrait s'étendre ou être placée dans le passage traversant 20.

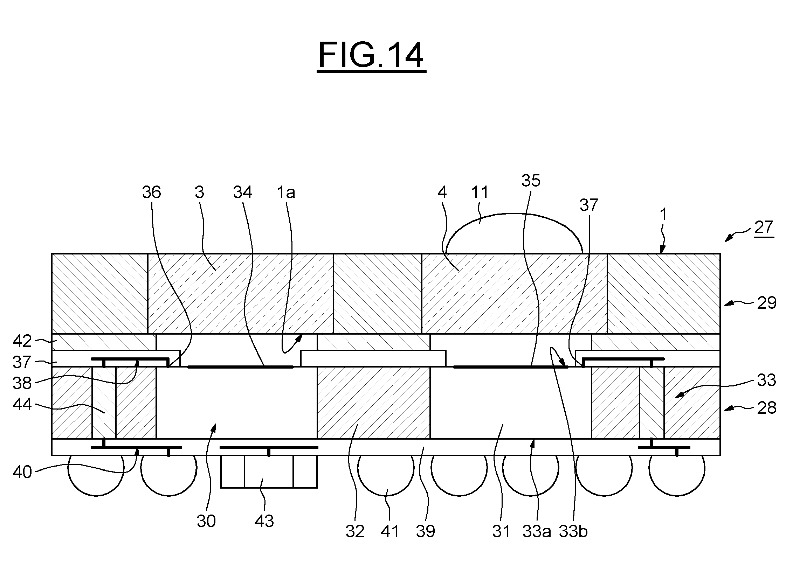

En se reportant à la figure 14, on va maintenant décrire un boîtier électronique 27.

Ce boîtier électronique 27 comprend un dispositif semi-conducteur 28 et un dispositif optique 29 qui est optiquement associé au dispositif semi-conducteur 28.

Le dispositif semi-conducteur 28 comprend, par exemple, deux puces de circuits intégrés 30 et 31 qui sont noyées, périphériquement, dans une plaque surmoulée 32 en une matière d'enrobage, par exemple en époxy, de façon à former une plaquette reconstituée 33 dont les faces avant et arrière, parallèles, sont définies par les faces avant et arrière des puces de circuits intégrés 30 et 31 et de la plaque 32. Le dispositif semi-conducteur 28 pourrait comprendre une seule puce de circuits intégrés ou plus de deux puces de circuits intégrés.

Les puces 30 et 31 présentent, sur ou dans leurs faces avant, des circuits intégrés optiques 34 et 35 et des plots de connexion électrique 36 et 37 situés autour de ces circuits intégrés 34 et 35. Selon une variante de réalisation, le circuit intégré 34 de la puce 30 peut être un émetteur de rayonnement lumineux et le circuit intégré 35 de la puce 31 peut être un capteur de rayonnement lumineux.

Le dispositif semi-conducteur 28 comprend une couche avant 36 formée sur la face avant 33b de la plaquette 33, qui ne recouvre pas les circuits intégrés 34 et 35 et dans laquelle est intégré un réseau avant de connexion électrique 38. Ce réseau de connexion électrique 38 est sélectivement relié aux plots de connexion 36 et 37 des puces 30 et 31.

Le dispositif semi-conducteur 28 comprend également une couche arrière 39 formée sur la face arrière 33a de la plaquette 33, dans laquelle est intégré un réseau arrière de connexion électrique 40. Ce réseau de connexion électrique 40 est sélectivement relié à une pluralité de billes de connexion électrique extérieure 41 placées sur la couche arrière 39.

Le dispositif semi-conducteur 28 comprend en outre une pluralité de vias de connexion électrique 42 qui s'étendent au travers de la plaque 32 et qui sont sélectivement reliés d'une part au réseau de connexion électrique 38 et d'autre part au réseau de connexion électrique 40.

Par ailleurs, le dispositif semi-conducteur 28 peut être équipé d'au moins un composant passif 43 fixé sur la couche arrière 39 et sélectivement relié au réseau arrière de connexion électrique 40, l'épaisseur de ce composant passif 43 étant au plus égal à l'épaisseur des billes de connexion électrique extérieure 41. Dans une variante de réalisation, le composant passif 43 pourrait être noyé dans la plaque 32, dans une position telle que sa face munie de moyens de connexion électrique soit sur la face 33a de la plaque 33, ces moyens de connexion étant reliés au réseau de connexion 40.

Ainsi, les puces 30 et 31, les billes de connexion électrique extérieure 41 et le composant passif 43 peuvent être sélectivement reliés de façon à alimenter les puces 30 et 31 en énergie électrique et à échanger des signaux électriques, par exemple avec une plaque de circuits imprimés sur laquelle les billes 41 peuvent être connectées.

Dans une variante de réalisation, le dispositif semi-conducteur 28 pourrait comprendre au moins une puce de circuits intégrés qui ne seraient pas optiques, reliée également au réseau de connexion électrique 38.

Le dispositif optique 29 peut être formé par l'un quelconque des dispositifs optiques 1, 14 ou 19 précédemment décrits, assemblés de la même manière au dispositif semi-conducteur 28.

Selon l'exemple représenté sur la figure 14, le dispositif optique 29 est formé par le dispositif optique 1 de la figure 4.

Selon cet exemple, la face arrière la du dispositif optique 1, formant une surface d'assemblage, est située du côté du dispositif semi-conducteur 28 et est fixée sur la couche avant 37 par l'intermédiaire d'une couche locale de colle 44, qui ne recouvre pas les circuits intégrés 34 et 35. Néanmoins, si cette couche 41 est en une colle transparente, les circuits intégrés 34 et 35 pourraient être recouverts.

Le dispositif optique 1 et le dispositif semi-conducteur 28 sont assemblés dans des positions relatives telles que la pastille optique 3 est située au-dessus des circuits intégrés 34, formant un émetteur, de la puce 30 et la pastille optique 4 munie à l'avant de la lentille 11 est située au-dessus des circuits intégrés 35, formant capteur, de la puce 31. D'autres dispositions pourraient être prévues.

Pour fabriquer le boîtier 27, le dispositif semi-conducteur 28 et le dispositif optique 29 peuvent être assemblés de plusieurs manières.

Des dispositifs 28 et 29 peuvent être individuellement assemblés.

Des dispositifs 28 individuels peuvent être assemblés sur des emplacements correspondant respectivement à des dispositifs 29 d'une plaquette comprenant une pluralité de dispositifs 29, et réciproquement, cette plaquette étant par la suite sciée de façon à singulariser les boîtiers.

Des plaquettes comprenant respectivement des pluralités de dispositifs 28 et 29 peuvent être assemblés dans une position adaptée, ces plaquettes étant par la suite sciées de façon à singulariser les différents boîtiers 27 à obtenir.

La présente invention ne se limite pas aux exemples ci-dessus décrits. Bien d'autres variantes de réalisation, par exemple combinant différemment les dispositifs décrits, sont possibles, sans sortir du cadre défini par les revendications annexées.

## Revendications

1. Dispositif optique comprenant :
au moins une pastille optique (4) et une plaque (2) en une matière d'encapsulation dans laquelle la pastille optique est noyée, au moins périphériquement, une première face (2a) de la plaque et une première face (4a) de la pastille optique s'étendant dans un même plan formant une surface d'assemblage (1a), une seconde face (4b) de la pastille optique opposée à sa première face étant au moins en partie découverte, de telle sorte que la pastille optique puisse être traversée par un rayonnement lumineux, d'un côté à l'autre de la plaque.

2. Dispositif optique selon la revendication 1, comprenant un élément optique (11) placé du côté de la seconde face de la pastille optique et associé optiquement à cette dernière.

3. Dispositif optique selon la revendication 1, comprenant, dans la plaque (2), deux pastilles optiques (3, 4).

4. Dispositif optique selon l'une des revendications 1 et 2, comprenant, dans la plaque (2), une pastille optique (4) et un passage traversant (20), ainsi qu'un élément optique (19a) associé à ce passage.

5. Procédé de fabrication d'un dispositif optique, comprenant :
placer une première face (4a) d'au moins une pastille optique (4) sur une surface (6a) d'un moule (6),
enrober, sur ladite surface du moule, la pastille optique d'une matière d'encapsulation, de façon à obtenir une couche intermédiaire surmoulée (8) plus épaisse que la pastille optique (4), et présentant une première face (2a) sur ladite surface (6a) du moule (6), ladite première face (2a) de la plaque et ladite première face (4a) de la pastille optique s'étendant dans un même plan formant une surface d'assemblage (1a),
et réaliser une opération d'enlèvement de la matière d'encapsulation du côté de la seconde face de la couche intermédiaire opposée à sa première face, au moins au-dessus d'au moins une partie d'une seconde face (4b) de la pastille optique opposée à sa première face (4a) de façon à découvrir cette partie, de façon à obtenir une plaque (2) dans laquelle la pastille optique (4) est noyée au moins périphériquement et que la pastille optique (4) puisse être traversée par un rayonnement lumineux, d'un côté à l'autre de la plaque (2).

6. Procédé selon la revendication 5, comprenant : réaliser une opération d'enlèvement et de planarisation de la matière d'encapsulation du côté de la seconde face de la plaque intermédiaire opposée à sa première face, au moins jusqu'à la seconde face (4b) de la pastille optique.

7. Procédé selon la revendication 5, comprenant : réaliser une ouverture (16) dans la couche intermédiaire (8) au moins au dessus d'au moins une partie de la seconde face de la pastille optique, de façon à obtenir une plaque (2) présentant cette ouverture.

8. Procédé selon l'une quelconque des revendications 5 à 7, comprenant : monter un élément optique (11) au-dessus de la seconde face (4) de la pastille optique.

9. Procédé selon la revendication 5, comprenant : enrober la pastille optique sur la surface du moule présentant une partie en saillie (23), de façon à aménager un évidement (26) dans la couche intermédiaire (25), l'opération d'enlèvement ouvrant cet évidement pour former un passage traversant (20) dans la plaque (2).

10. Procédé selon la revendication 9, comprenant : monter un élément optique (19a) au-dessus ou dans le passage traversant (20) dans la plaque (2).

11. Boîtier électronique comprenant :
un dispositif semi-conducteur (28) comprenant au moins une puce de circuits intégrés (31) présentant, d'un côté, au moins des circuits intégrés optiques (35) ;
un dispositif optique (29) selon l'une quelconque des revendications 1 à 4, placé de telle sorte que la pastille optique soit au-dessus des circuits intégrés (31), dans une position telle que ladite surface d'assemblage (1a) est du côté du dispositif semi-conducteur (28) ;
et un moyen de fixation du dispositif optique (29) sur le dispositif semi-conducteur (28).

12. Boîtier selon la revendication 11, dans lequel le dispositif semi-conducteur comprend une plaque (32) en une matière d'encapsulation dans laquelle la puce est noyée, au moins périphériquement, en laissant découvert ledit élément optique intégré, la plaque du dispositif semi-conducteur étant munie de moyens de connexion électrique (38, 40, 42) d'une face à l'autre, reliés électriquement à la puce.

13. Boîtier selon l'une des revendications 11 et 12, dans lequel le moyen de fixation du dispositif optique sur le dispositif semi-conducteur est formé par une couche de colle (44) interposée entre eux.

14. Boîtier selon l'une quelconque des revendications 11 à 13, dans lequel le dispositif semi-conducteur (28) comprend au moins un composant passif (43) relié aux moyens de connexion électrique.

15. Boîtier selon l'une quelconque des revendications 11 à 14, dans lequel le dispositif semi-conducteur comprend au moins deux puces de circuits intégrés optiques (30, 31), dont une puce comprenant un émetteur de rayonnement lumineux et une puce comprenant un capteur de rayonnement lumineux, et dans lequel le dispositif optique comprend une pastille (3) au-dessus de l'une des puces et une pastille (4) ou un passage (20) associé à un élément optique (19a) au-dessus de l'autre puce.
